Europäisches Patentamt
European Patent Office
Office européen des brevets

(19)

(11) Veröffentlichungsnummer: 0 019 802
B1

(12) # EUROPÄISCHE PATENTSCHRIFT

(45) Veröffentlichungstag der Patentschrift: 12.09.84

(51) Int. Cl.³: H 05 K 3/28

(21) Anmeldenummer: 80102680.8

(22) Anmeldetag: 14.05.80

(54) **Im Siebdruck verarbeitbare und wieder entfernbare Lötmaskenzusammensetzung und Verfahren zum Herstellen einer wieder entfernbaren Lötmaske.**

(30) Priorität: 04.06.79 US 45524

(43) Veröffentlichungstag der Anmeldung: 10.12.80 Patentblatt 80/25

(45) Bekanntmachung des Hinweises auf die Patenterteilung: 12.09.84 Patentblatt 84/37

(84) Benannte Vertragsstaaten: DE FR GB

(56) Entgegenhaltungen:
CH - A - 429 169
CH - A - 486 186
DE - A - 2 411 398
DE - A - 2 424 367
DE - B - 2 317 709
FR - A - 2 235 158
US - A - 3 288 754
US - A - 3 305 504
US - A - 3 440 203
US - A - 3 556 754
US - A - 3 781 237
US - A - 3 816 364
US - A - 3 843 577
US - A - 3 926 885
US - A - 4 121 000

(73) Patentinhaber: International Business Machines Corporation, Old Orchard Road, Armonk, N.Y. 10504 (US)

(72) Erfinder: Bakos, Peter, 530A Reuben Drive, Endicott New York 13760 (US)
Erfinder: Darrow, Russell Elwood, RD 1, Stratton Road, Newark Valley New York 13811 (US)
Erfinder: Rivenburgh, Dennis Louis, 804 Buffalo Road, Endicott New York 13760 (US)
Erfinder: Williams, William Francis, RD 2, Echo Road, Vestal New York 13850 (US)

(74) Vertreter: Kreidler, Eva-Maria, Dr. rer. nat., Schönaicher Strasse 220, D-7030 Böblingen (DE)

EP 0 019 802 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine im Siebdruck verarbeitbare und wieder entfernbare Lötmaskenzusammensetzung mit einem Gehalt an A) einem filmbildenden Polymeren in flüssiger Form, B) einem das Kleben verhindernden Mittel und C) einem festen, hochtemperaturbeständigen Füllstoff und ein Verfahren zum Herstellen einer wieder entfernbaren Lötmaske.

Die Erfindung ermöglicht, bestimmte Bereiche einer Unterlage durch die Lötmaske vor der Abscheidung eines Lotes zu schützen und gestattet die Entfernung der Lötmaske nach dem Abscheiden des Lotes. Die Lötmaskenzusammensetzung und das Verfahren zur Herstellung einer Lötmaske ist besonders wichtig bei der Herstellung mehrlagiger elektronischer Bauteile, bei denen eine Verbindung zwischen dem Träger oder der Unterlage und der integrierten Halbleiteranordnung oder dem Chip hergestellt werden soll. Die vorliegende Erfindung ist insbesondere anwendbar zur Herstellung von Produkten, bei denen mehr als ein Chip oder mehr als eine Halbleiteranordnung auf einem einzigen Träger oder Unterlage befestigt werden sollen.

Mehrlagige elektronische Bauelemente können hergestellt werden, indem man auf eine keramische Unterlage oder einen Träger eine Chromschicht, eine Kupferschicht und anschliessend wieder eine Chromschicht aufträgt. Danach wird eine Photoresistzusammensetzung aufgetragen, so dass bestimmte Bereiche der Chrom-/Kupfer-/Chromschichten entfernt werden können und die gewünschten elektrischen Verbindungen auf der Unterlage hergestellt werden können. Die oberste Chromschicht wird in bestimmten Bereichen mittels bekannter Ätzverfahren entfernt. Die oberste Chromschicht wird aufgetragen, damit das nachfolgend aufgebrachte Lot in denjenigen Bereichen, in denen das Chrom vorhanden ist, nicht an der Unterlage haftet. Anschliessend wird das freigelegte Kupfer in bestimmten Bereichen entfernt, wo sich Lot abscheiden soll, beispielsweise um die Löcher, in die nachfolgend Stifte eingeführt werden und an Stellen, an denen die Halbleiterchips durch Auflöten mit der Unterlage verbunden werden. Die Kupferschicht bewirkt die elektrische Leitfähigkeit. Anschliessend werden die freiliegenden Bereiche der untersten Chromschicht durch Ätzen entfernt. Die unterste Chromschicht wird aufgetragen, um eine ausreichende Haftung zwischen der Kupferschicht und der Keramikunterlage zu gewährleisten. Nachdem die Eingangs-/Ausgangs-Stifte in die Unterlage eingeführt sind, wird Lot auf die Unterlage aufgetragen und auf den Eingangs-/Ausgangs-Stiften und den freiliegenden Kupferbereichen abgeschieden, jedoch nicht auf der Unterlage selbst und den freiliegenden Chrombereichen.

Bei diesem Verfahren treten Probleme dadurch auf, dass sich das Lot bei seiner Anwendung in kugelförmigen Niederschlägen auf den freiliegenden Bereichen abscheidet und die Abscheidungen unterschiedliche Höhen haben. Dies spielt in den Bereichen eine Rolle, in denen anschliessend das Chip mit der Unterlage verbunden werden soll. Diese Bereiche werden im allgemeinen als Chip-Anschlussstellenbereiche bezeichnet. Durch die unebenen Abscheidungen in den Chip-Anschlussstellenbereichen können elektrische Kurzschlüsse und Fehler durch Wärmeübertragung auftreten. Das Lot wird auch auf die integrierten Schaltkreischips selbst aufgetragen, dieser Überzug ist jedoch ein im wesentlichen einheitlicher und ebener Überzug, weil er durch Aufdampfen aufgetragen wird. Verfahren dieser Art sind nicht besonders zur Anwendung des Lots auf die Unterlage geeignet, weil Aufdampfverfahren relativ kostspielig sind und zu langsam für die Fertigung von Teilen in hoher Stückzahl. Ausserdem können die bei der Aufdampfung des Lots angewendeten hohen Temperaturen auch die Photomasken zerstören, wodurch die Photomaske ihre ursprüngliche Funktion, nämlich die Bereiche, in denen das Lot abgeschieden werden soll, abzugrenzen, nicht mehr erfüllt.

Die zuvor geschilderten Probleme werden durch das Verfahren gemäss der Erfindung vermieden. Erfindungsgemäss werden bestimmte Zusammensetzungen im Chip-Anschlussstellenbereich aufgetragen, um diese gegen eine Abscheidung des Lots auf freigelegtem Kupfer zu schützen. Nach der Entfernung der Zusammensetzung ist nur auf dem Chip Lot vorhanden, welches zur Verbindung des Chips mit der Unterlage benötigt wird, und dieses bildet, wie zuvor angegeben, einen ebenen Überzug. Dadurch wird eine einheitliche Höhe und eine erhöhte Zuverlässigkeit der Mehrlagenbauelemente erhalten. Weil ursprünglich auf dem Kupfer und dem Chip-Anschlussstellenbereich kein Lot vorhanden war, wird auch die Bindungsstärke zwischen Chip und Unterlage nicht negativ beeinträchtigt.

Eine Zusammensetzung, die für den zuvor angegebenen Zweck geeignet ist, muss eine Anzahl von Eigenschaften aufweisen, von denen einige anderen erforderlichen Eigenschaften zu widersprechen scheinen. Beispielsweise muss sich die Zusammensetzung genau auf den gewünschten Bereich, der vor dem Lot geschützt werden soll, auftragen lassen. Dazu ist es erforderlich, dass die Zusammensetzung eine bestimmte Fliesscharakteristik aufweist.

Die Zusammensetzung muss gegenüber dem Lot unter den Bedingungen, unter denen dieses auf die Unterlage aufgetragen wird, widerstandsfähig sein. Ausserdem muss die Zusammensetzung hinreichend auf der Unterlage haften, so dass das Lot nicht unter dieser eindringt und mit denjenigen Kupferbereichen, die geschützt werden sollen, in Berührung kommt. Im Gegensatz zu dieser Haftung auf der Unterlage ist es jedoch erforderlich, dass die Zusammensetzung nicht so stark an der Unterlage haftet, dass eine nachfolgende Entfernung der Zusammensetzung unmöglich ist und/oder die Unterlage oder andere auf dieser befindliche Schichten zerstört werden. Die Zusammensetzung, die leicht wieder entfernbar sein muss, muss hinreichend auf der Unterlage

haften, damit sie für den vorgesehenen Verwendungszweck geeignet ist.

Die Bereitstellung von Zusammensetzungen mit allen zuvor beschriebenen Eigenschaften ist sehr schwierig. Die Auffindung geeigneter Zusammensetzungen wird auch dadurch erschwert, dass integrierte Schaltkreise viel komplexer werden und verschiedene Muster auf den Unterlagen sehr nahe aneinanderrücken und schwieriger herstellbar sind. Deshalb sind die Anforderungen an die gewünschte Zusammensetzung hinsichtlich der Herstellung von Mustern ganz besonders hoch.

Aus der deutschen Offenlegungsschrift 2 411 398 ist zwar eine photohärtbare Zusammensetzung für den Siebdruck mit einem Gehalt an einem Polyen, einem Polythiol und einem Siliconöl bekannt, die eine Zeit lang mit aktinischer Strahlung belichtet wird, bis das gesamte Polythiol mit Polyen reagiert hat, dass dann unter Ausschluss von Strahlung so viel Polythiol zugesetzt wird, dass mindestens 50% des anfänglich eingesetzten Polyens reagiert, so dass die Mischung eine bestimmte Viskosität aufweist. Die zuvor angegebene Zusammensetzung ist zur Beschichtung von Schaltkarten und Platten im Siebdruck geeignet, nach dem Härten durch aktinische Strahlung ist sie jedoch nicht mehr von der Unterlage entfernbar. Ausserdem enthält sie einen anderen Polymeranteil und keinen Füllstoff.

Aufgabe der Erfindung ist, eine Zusammensetzung anzugeben, mit der die Abscheidung eines Lots in bestimmten Bereichen, beispielsweise im Chip-Anschlussstellenbereich, auf einer Unterlage verhindert werden kann und die nach dem Löten wieder leicht entfernbar ist.

Die Erfindung gemäss den Patentansprüchen löst diese Aufgabe. Gemäss dem Kennzeichen des Patentanspruchs 1 wird eine Lötmaskenzusammensetzung mit einem Gehalt an A) einem Polyepoxid aus Epichlorhydrin und 2,2-Bis(p-hydroxyphenyl)propan mit einer Viskosität von 0,4 bis 3 Pa.s bei 25 °C und einem Molekulargewicht von 170 bis 250, B) einem flüssigen Siliconöl als das Kleben verhinderndes Mittel und C) einem festen, hochtemperaturbeständigen Füllstoff aus der Gruppe von gemahlenem Glas, Zinkoxid, Siliciumdioxid, Aluminiumoxid, Sand und Mischungen derselben bereitgestellt.

Durch die Erfindung werden grosse Lotmengen und dadurch hervorgerufene Kurzschlüsse im Chip-Anschlussstellenbereich und eine Fleckenbildung durch Flussmittel vermieden. Ausserdem wird eine ebene Fläche für die Ausrichtung der Chips und das Wiederaufschmelzen des Lotes geschaffen und die Grösse des Chip-Anschlussstellenbereichs nicht herabgesetzt. Die erfindungsgemässe Zusammensetzung lässt sich zu einem Muster mit hoher Auflösung verarbeiten und ist nach dem Löten ohne Rückstand von der Unterlage entfernbar.

Die Erfindung wird durch die US-Patentschriften 3 843 577 und 3 926 885, die Zusammensetzungen mit einem Gehalt an Polyepoxid und bestimmten Siloxanen angeben, nicht nahegelegt, weil gemäss diesen Patentschriften die Anwesenheit eines nichtverträglichen Schmiermittels und auch eines Härtungsmittels erforderlich ist. Auch sind die diesen Patentschriften die Eigenschaften, die mit der Zusammensetzung gemäss der vorliegenden Erfindung erhalten werden, nicht beschrieben, und gerade diese werden mit den Zusammensetzungen gemäss der beiden Patentschriften wegen der Anwesenheit von Härtungsmitteln nicht erreicht.

In der US-Patentschrift 4 121 000 ist auch eine Zusammensetzung beschrieben, die ein Epoxidpolymer und eine Polysiloxanflüssigkeit enthält. Daneben liegen jedoch grosse Mengen eines anderen Polymermaterials und auch Härtungsmittel vor.

In der US-Patentschrift 3 816 364 sind bestimmte Zusammensetzungen mit einem Gehalt an Epoxid und Dimethylsilicon beschrieben. Die dort verwendeten Epoxide sind jedoch feste Epoxide, und die Mengen an Silicon sind andere als in der vorliegenden Erfindung.

In der US-Patentschrift 3 556 754 sind Zusammensetzungen beschrieben, die einen bestimmten Typ eines Silicons und eines Polymeren enthalten, welches beispielsweise ein Epoxid sein kann und die zur Schlichtung von Glasfasern verwendet werden. Auch diese Patentschrift nimmt die vorliegende Erfindung nicht vorweg, weil die dort beschriebene Menge an Silicon sehr viel niedriger ist als in der vorliegenden Erfindung.

In der US-Patentschrift 3 305 504 wird eine Zusammensetzung mit einem Gehalt an Epoxid und einem Siliconkautschuk beschrieben. Auch dieses Patent nimmt die vorliegende Erfindung nicht vorweg, weil unter anderem in der dort beschriebenen Zusammensetzung ein Siliconkautschuk und gemäss der vorliegenden Erfindung ein Siliconöl verwendet wird.

Die vorliegende Erfindung betrifft eine im Siebdruck verarbeitbare und wieder entfernbare Lötmaskenzusammensetzung. Die Zusammensetzung enthält einen filmbildenden Polymeranteil in Form einer flüssigen Zusammensetzung, wobei das Polymere ein flüssiges Polyepoxid ist. Die Zusammensetzung enthält auch ein das Kleben verhinderndes Mittel, welches mit dem Polymer verträglich ist und ein flüssiges Siliconöl ist. In der Zusammensetzung ist auch ein fester, hochtemperaturbeständiger Füllstoff vorhanden, der in einer solchen Menge angewendet wird, dass sich die Zusammensetzung nach dem Löten von der Unterlage wieder entfernen lässt. Das Verhältnis von Polymer im Polymerteil zu dem das Kleben verhindernde Mittel liegt vorzugsweise zwischen 2:1 und 1:3. Wenn ein Polyepoxid verwendet wird, enthält das das Kleben verhindernde Mittel ein flüssiges Siliconöl. Das zuvor angegebene Verhältnis zwischen Polymerkomponente und dem Mittel, das das Kleben verhindert, basiert auf der Gesamtmenge an Polymer in dem Polymeranteil und dem Mittel, das das Kleben verhindert und schliesst beispielsweise etwa vorhandene Mengen an Lösungsmittel, die das Polymer in eine flüssige Polymerzusammensetzung überführen, nicht ein.

Die vorliegende Erfindung betrifft auch ein Verfahren zum Herstellen einer wieder entfernbaren Lötmaske, mit der bestimmte Bereiche der Unterlage vor der Einwirkung eines Lots während der Lötoperation geschützt werden können. Das erfindungsgemässe Verfahren betrifft das Aufbringen einer Lötmaskenzusammensetzung im Siebdruck auf eine Unterlage in einem bestimmten Muster. Die beschichtete Unterlage wird zur Härtung der Zusammensetzung getrocknet. Anschliessend wird ein Lot aufgetragen, wobei das Lot in denjenigen Bereichen, die durch die gehärtete Lötmaske bedeckt sind, nicht an der Unterlage haftet. Nach der Einwirkung des Lots wird die Lötmaske von der Unterlage entfernt. Die im Siebdruck verarbeitbare und wieder entfernbare Lötmaskenzusammensetzung gemäss der vorliegenden Erfindung enthält einen filmbildenden Polymeranteil in Form einer flüssigen Zusammensetzung, ein Mittel, das Kleben verhindert und einen festen, hochtemperaturbeständigen Füllstoff.

Der filmbildende Polymeranteil der Zusammensetzung ist ein flüssiges Polyepoxid. Der Polymeranteil der Zusammensetzung muss in Form einer flüssigen Zusammensetzung vorliegen. Dementsprechend kann der Polymeranteil entweder ein Polyepoxid, welches bereits flüssig ist, oder eine Lösung oder Dispersion desselben in einem nichtreaktiven Lösungsmittel sein.

Die flüssigen Epoxidpolymeren, die erfindungsgemäss verwendet werden, sind Polyepoxide aus Epichlorhydrin und Bisphenol-A, d.h. 2,2-Bis(p-hydroxyphenyl)propan.

Die Zusammensetzung muss auch einen Bestandteil enthalten, der das Kleben verhindert, der aber mit dem Polymeranteil der Zusammensetzung verträglich ist. Dieses Mittel reduziert die Klebrigkeit der Zusammensetzung, wodurch sie sich im Siebdruckverfahren, das zum Auftragen der Zusammensetzungen in einem vorbestimmten Muster auf Unterlagen angewendet wird, leichter auftragen lässt. Dies ist besonders wichtig, weil bei zunehmender Feinheit der Siebe die Kontrolle der Klebrigkeit und auch der Viskosität an Bedeutung zunimmt.

Das Mittel, welches das Kleben der Zusammensetzung verhindert, dient auch zur Einstellung der Viskosität, damit die gewünschte Viskosität der Zusammensetzung für den Siebdruck erhalten wird und damit die im Siebdruck verarbeitbare Zusammensetzung, insbesondere für den beabsichtigten Zweck der vorliegenden Erfindung, bei der Herstellung von elektronischen Schaltungen geeignet ist. Was das Nichtklebrigsein anbetrifft, so darf die Zusammensetzung bei ihrem Auftrag nicht am Sieb kleben bleiben, sonst findet eine Verformung des Musters statt bei der Entfernung von der Unterlage.

Das Mittel, das das Kleben der Zusammensetzung verhindert, wird tatsächlich während des Trocknens und/oder der Lötoperation durch Zersetzung und Verdampfung entfernt. Das Mittel, das das Kleben verhindert, sollte nicht in unerwünschtem Masse verkohlen und einen Rückstand auf der Unterlage zurücklassen, der im nachfolgenden Reinigungs- und Entfernungsverfahren schwierig zu entfernen ist.

Für ein flüssiges Polyepoxid als filmbildendes Polymer ist das das Kleben verhindernde Mittel ein flüssiges Siliconöl. Es ist wesentlich, dass bei Anwendung eines flüssigen Polyepoxids als filmbildendes Polymer ein Siliconöl als das Kleben verhinderndes Mittel verwendet wird, weil das Siliconöl bei der nachfolgenden Polymerisation des Epoxids vor dem Kontakt mit der Lötzusammensetzung mitwirkt. Die das Kleben verhindernden Mittel, die erfindungsgemäss verwendet werden, weisen im allgemeinen Viskositäten von etwa 0,025 bis 0,5 Pa.s bei 25 °C auf.

Die flüssigen Siliconöle, die erfindungsgemäss verwendet werden können, sind gut bekannte Materialien. Beispielsweise enthalten viele Silicone zwei oder mehr Siloxaneinheiten, wie aus der nachfolgenden Formel einer mittleren Einheit ersichtlich ist.

$$[OH]_X[OR_1]_Y[R]_z\,SiO_{\frac{4-x-y-z}{2}}$$

Im einzelnen ist jeder Rest R ein Alkyl-, Cycloalkyl-, Alkenyl-, Aryl-, Aralkyl oder Cycloalkenyl-Rest, ein halogeniertes Derivat der zuvor angegebenen Reste und ein Cyanalkyl-Rest. $OR_1$ ist ein Alkoxy- oder Acyloxy-Rest. Wenn es gewünscht wird, können auch Mischungen der oben definierten Reste R und $OR_1$ angewendet werden.

Im allgemeinen hat x einen Wert von etwa 0 bis 1, y einen Wert von etwa 0 bis 1 und die Summe $x + y$ einen Wert von etwa 0 bis 1 und z einen Wert von etwa 1 bis 2.

Der Rest R wird vorzugsweise gewählt aus einer Gruppe von Niedrigalkyl-Resten mit 1 bis 18 Kohlenstoffatomen; aus Cycloalkyl-Resten mit 5 bis 7 Kohlenstoffatomen im Ring; Niedrigalkyl-Resten mit 2 bis 8 Kohlenstoffatomen; einkernigen Aryl-Resten; einkernigen Aryl-Niedrigalkyl-Resten mit 1 bis 6 Kohlenstoffatomen in der Alkylgruppe; Cycloalkenyl-Resten mit 5 bis 7 Kohlenstoffatomen im Ring und halogenierten Derivaten dieser Reste.

Im einzelnen wird R gewählt aus der Klasse der Niedrigalkyl-Reste, d.h. aus Resten wie Methyl, Äthyl, Propyl, Butyl, Octyl und Octadecyl; aus Cycloalkyl- und Cycloalkenyl-Resten mit 5 bis 7 Kohlenstoffatomen im Ring, d.h. aus Cyclopentyl, Cyclohexyl, Cycloheptyl und Cyclohexenyl-Resten; aus Niedrigalkenyl-Resten, d.h. aus Vinyl- und Allyl-Resten; aus einkernigen Aryl-Resten, d.h. aus Phenyl, Tolyl und Xylyl-Resten; aus einkernigen Aryl-Niedrigalkyl-Resten, d.h. aus Benzyl- und Phenyläthyl-Resten; halogenierten Derivaten der zuvor angegebenen Reste und Cyanalkyl-Resten, d.h. aus Chlormethyl, β-Chloräthyl, Chlorphenyl, Dibromphenyl und Trifluormethyläthyl-Resten. Vorzugsweise wird R gewählt aus der Klasse von Methyl, Äthyl und Phenyl.

Der Alkoxy-Rest $OR_1$ wird gewählt aus der Klasse der Niedrigalkoxy-Reste mit 1 bis 8 Kohlenstoffatomen, d.h. aus Methoxy, Äthoxy, Propoxy und Isopropoxy-Resten. Der Acyl-Rest $R_1CO$ ist ein

Acyl-Rest einer gesättigten aliphatischen Monocarbonsäure wie Formyl, Acetyl, Propionyl, Butyryl, Henoyl, 2-Äthylhexoyl, Octanoyl, Isovaleryl und Stearyl, wobei Acetyl bevorzugt wird. Es sei auch bemerkt, dass Copolymere, welche zwei oder mehr verschiedene Siloxaneinheiten enthalten, verwendet werden können. Als Endgruppen können in den Siliconflüssigkeiten diejenigen, welche zur Blockierung von Endgruppen bei Siliconpolymeren bekannt sind, verwendet werden. Als bevorzugte Siliconflüssigkeiten gemäss der vorliegenden Erfindung kommen flüssige Polydimethylsiloxane und insbesondere solche, bei denen beide Enden des Polymeren mit drei Methylgruppen besetzt sind, in Frage. Die Anzahl der sich wiederholenden Einheiten des Silicons wird so gewählt, dass eine Viskosität der Siliconzusammensetzung im Bereich von etwa 0,05 bis 0,5 Pa.s bei 25 °C erhalten wird. Die Viskosität soll vorzugsweise bei etwa 0,1 bis 0,3 Pa.s liegen.

Wenn es gewünscht wird, können auch Mischungen der verschiedenen Mittel zur Verhinderung des Klebens verwendet werden, unter der Voraussetzung, dass sie untereinander und mit dem speziell verwendeten Polymer verträglich sind.

Als das Kleben verhinderndes Mittel muss ein solches verwendet werden, das im wesentlichen aus der Zusammensetzung während des Trocknens und/oder Lötens durch Zersetzung oder Verdampfung entfernt wird. Es sollte auch nicht im grösseren Ausmass verkohlen und einen unerwünschten Rückstand auf der Oberfläche der Unterlage zurücklassen, welches anschliessend schwierig zu entfernen ist.

Die im Siebdruck verarbeitbare und wieder entfernbare Lötmaskenzusammensetzung der vorliegenden Erfindung enthält auch einen festen Füllstoff. Der feste Füllstoff muss erhöhten Temperaturen ausgesetzt werden können. Insbesondere muss er gegen erhöhte Temperaturen, die beim Aufbringen des heissen Lotes auftreten, beständig sein und wenigstens etwa 300 °C und vorzugsweise wenigstens etwa 350 °C aushalten. Das Lot wird im allgemeinen bei Temperaturen zwischen etwa 300 und 400 °C aufgetragen. Beispiele einiger geeigneter fester, hochtemperaturbeständiger Füllstoffe schliessen gemahlenes Glas, Zinkoxid, Siliciumdioxid, Aluminiumoxid und Sand ein.

Der verwendete Füllstoff hat im allgemeinen eine Teilchengrösse von etwa 0,1 bis 20 µm und vorzugsweise von etwa 0,1 bis 5 µm. Es ist wesentlich, dass der Füllstoff eine feine Teilchengrösse besitzt, damit er sich für die Herstellung mehrlagiger elektronischer Schaltkreise eignet. Die Menge des Füllstoffs wird so gewählt, dass die Zusammensetzung leicht nach ihrer Verwendung von der Unterlage, beispielsweise durch blosses Waschen entfernt werden kann. Es wird angenommen, dass der Füllstoff dazu neigt, die Polymerisation oder die Vernetzung des filmbildenden Materials zu Molekülen von sehr grossem Molekulargewicht zu verzögern, wodurch verhindert wird, dass das Polymer zu zäh an der Unterlage haftet. Anderseits müssen der Typ, die Grösse und die Menge des Füllstoffs so gewählt werden, dass die Bindung zwischen der Unterlage und der Zusammensetzung nicht in dem Masse zerstört wird, dass eine Verwendung der Zusammensetzung als Lötmaske ausgeschlossen ist. Die Zusammensetzung sollte auch im wesentlichen, wenn nicht ganz, frei von Härtungsmitteln für die Polymeren der Zusammensetzung sein.

Die erfindungsgemäss verwendeten Zusammensetzungen weisen im allgemeinen eine Viskosität von etwa 7,0 bis 15,0 Pa.s bei 25 °C auf. Bevorzugte Viskositäten der Zusammensetzungen liegen zwischen etwa 1,0 uns 1,3 und besonders bevorzugte zwischen etwa 7,0 bis 12,5 Pa.s bei 25 °C.

Das Verhältnis des filmbildenden Polymers im Polymeranteil der Zusammensetzung relativ zu dem das Kleben verhindernden Mittel liegt im allgemeinen zwischen etwa 2:1 und 1:3 und vorzugsweise zwischen etwa 1:1 und 2:3. Das Verhältnis von Füllstoff relativ zu der filmbildenden Polymerkomponente des Polymeranteils der Zusammensetzung liegt zwischen etwa 1:6 bis 6:1 und vorzugsweise bei etwa 2:1 bis 6:1. Die Zusammensetzung darf mit dem Lot unter dessen Anwendungsbedingungen nicht mischbar sein. Es sollten auch die Bestandteile der Zusammensetzung miteinander verträglich sein.

Ein typisches Verfahren für die Anwendung der im Siebdruck verarbeitbaren und wieder entfernbaren Lötmaskenzusammensetzung gemäss der vorliegenden Erfindung umfasst das Auftragen der Lötzusammensetzung auf eine Unterlage, beispielsweise auf ein keramisches Substrat in einem bestimmten Bereich, in dem der integrierte Schaltkreis-Chip anschliessend befestigt wird. Ein keramisches Material wird hergestellt durch die Einwirkung von Hitze auf bestimmte Erden als Rohmaterial. Bevorzugte keramische Unterlagen enthalten Siliciumdioxid und Silicate, wie Aluminiumsilicat und Aluminiumoxide.

Die Unterlagen können vorgebildete Löcher enthalten, durch die Eingangs- und Ausgangs-Stifte eingeführt werden können, die aus einer Oberfläche der Unterlage hervorragen und die zur Befestigung an Schaltkreiskarten oder Platten dienen. Die Stifte regen auch ganz geringfügig aus der anderen Oberfläche, die als Rückseite bezeichnet wird, heraus, so dass sie mit der Schaltung auf der Rückseite in Kontakt sind, die ihrerseits eine Verbindung zwischen dem integrierten Schaltkreis-Chip, welches auf die Rückseite der Unterlage aufgetragen wird, herstellt. Der Bereich, der vor dem Lot geschützt und abgeschirmt werden soll, wird durch Anwendung eines Siebdruckverfahrens bestimmt. Der Überzug wird im allgemeinen auf die Unterlage in Schichtdicken von etwa 0,025 bis 0,635 mm, vorzugsweise von etwa 0,127 bis 0,25 mm und insbesondere bevorzugt in einer Schichtdicke von etwa 0,051 bis 0,076 mm aufgetragen.

Die beschichteten Unterlagen werden dann getrocknet, um eine Härtung der Überzugszusammensetzung zu bewirken. Das Trocknen wird im allgemeinen bei etwa 50 bis 150 °C durchgeführt

und ist nach etwa 10 bis 30 Minuten abgeschlossen. Dieser Schritt kann auch bis zu einem gewissen Grad, wenn auch nicht vollständig, die Zersetzung und Verdampfung des das Kleben verhindernden Mittels der Zusammensetzung bewirken. Die Unterlagen werden dann mit Stiften versehen unter Verwendung der hierfür üblichen Vorrichtungen. Weniger vorzuziehen ist, die Unterlagen vor Auftragen der Beschichtung mit Stiften zu versehen. Nach dem Anbringen der Stifte und dem Härten der Überzugszusammensetzung werden die Unterlagen mit Lötzinn versehen oder mit dem Lot in einem Tauchbeschichter oder mittels einer Lötwelle versehen. Während des Lötens oder Verzinnens sind die Bereiche, die mit einer Lötmaske bedeckt sind, vor dem Lot geschützt. Das Lot oder Zinn haftet nur an dem freiliegenden Kupfer der Unterlagen, d.h. an den Stiften und in den Bereichen um dieselben. Das Zinn oder Lot wird im allgemeinen bei Temperaturen zwischen 300 und 400 °C aufgetragen. Während des Lötens zersetzt sich das noch vorhandene Mittel zum Verhindern des Klebens und verdampft.

Nach dem Abschrecken der gelöteten Unterlage und dem damit verbundenen schnellen Temperaturwechsel und der Kontraktionsunterschiede zwischen Unterlage und Zusammensetzung bricht die Maskenzusammensetzung und löst sich von der Unterlage. Irgendwelche noch zurückbleibende Maskenzusammensetzung kann von der Unterlage durch leichtes Bürsten und/oder durch kurzzeitiges Anwenden eines Lösungsmittels wie N-Methyl-2-pyrrolidon oder Trichloräthylen oder Perchloräthylen entfernt werden. Der Kontakt mit den Lösungsmitteln sollte herbeigeführt werden, während die Unterlage sich auf einer Temperatur zwischen 100 und 180 °C befindet und zwar etwa 10 Sekunden bis 2 Minuten nach Beendigung der Lötoperation. Der Kontakt mit den Lösungsmitteln dauert im allgemeinen etwa 4 Sekunden bis 60 Sekunden und vorzugsweise etwa 4 bis 25 Sekunden. Das Lösungsmittel kann auf die Unterlage aufgesprüht werden, beispielsweise bei Drucken von etwa 0,07 bis 56,2 N/cm² und vorzugsweise von 21,1 bis 42,2 N/cm². Wenn es gewünscht wird, kann die Unterlage auch bewegt werden, beispielsweise mit etwa 20 bis 30 Schwingungen mit einer seitlichen Auslenkung von etwa 1,27 bis 5,08 mm oder bei 120 bis 160 Schwingungen mit einer seitlichen Auslenkung von etwa 0,127 bis 0,635 mm, wodurch die Entfernung von Teilchen bewirkt wird. Weiterhin kann ein Luftstrahl auf die Unterlagen gerichtet werden und in verstärktem Masse die Entfernung irgendwelcher Teilchen, die von der Lötmaske zurückbleiben, bewirken. Es sei bemerkt, dass, wenn die Unterlagen vor Entfernung der Lötmaskenzusammensetzung durch Einwirkung der Lösungsmittel auf Zimmertemperatur abgekühlt werden, es erforderlich ist, die Unterlagen wieder mit einem Lötflussmittel und Lötzinn zu versehen und dann abzuschrecken, um die Entfernung der Lötmaskenzusammensetzung zu diesem Zeitpunkt des Verfahrens zu erleichtern.

Das Löten wird im allgemeinen nach etwa 5 bis 25 Sekunden abgeschlossen. Die Unterlagen sind dann für weitere Verfahrensschritte bereit, beispielsweise für die Belegung mit den gewünschten integrierten Schaltkreis-Chips, wobei nur das Lot auf dem Chip zur Befestigung an der Unterlage dient im Gegensatz zum Stand der Technik, nach dem beide, Chip und Unterlage, Lot enthalten. Wie zuvor beschrieben, bietet die Erfindung eine Reihe wesentlicher Vorteile, insbesondere bei der Herstellung von mehrlagigen Schaltungen unter Verwendung integrierter Schaltkreise. Einige Vorteile sind die Eliminierung einer hohen Menge an Lot zwischen Chip und Anschlussstelle, die Eliminierung von Kurzschlüssen im Chip-Anschlussstellenbereich, die Vermeidung von Lötflussmittelflecken im Chip-Anschlussstellenbereich, die Vermeidung einer Chromabscheidung oder eines Kurzschlusses im Chip-Anschlussstellenbereich, die Bereitstellung einer ebenen Fläche für die Chip-Ausrichtung und das Aufschmelzen des Lotes und die Vermeidung der Verkleinerung der Chip-Anschlussstelle. Beispielsweise wird normalerweise während der Lötoperation eine endliche Menge Kupfer in dem Lot gelöst. Dementsprechend reduziert diese Entfernung von Kupfer die Kupfermenge im Anschlussstellenbereich.

Die Erfindung wird anhand der nachfolgenden Ausführungsbeispiele näher erläutert.

Beispiel 1

Eine Zusammensetzung, die etwa 10 Gewichtsteile eines Epichlorhydrin-Bisphenol-A Epoxidharzes mit einem Molekulargewicht von etwa 200, das unter der Handelsbezeichnung Shell Epon 28 erhältlich ist, etwa 65 Gewichtsteile Siliciumdioxid mit einer Partikelgrösse von etwa 0,3 µm und etwa 15 Gewichtsteile Polydimethylsiloxan, dessen Enden mit Methylgruppen blockiert sind und das eine Viskosität von etwa 0,2 Pa.s aufweist und von Dow Corning unter der Handelsbezeichnung Fluide Nr. 200 erhältlich ist, enthält, wird gemischt. Die Zusammensetzung wird im Siebdruck auf eine mit Kupfer beschichtete keramische Unterlage aufgetragen und etwa 25 Minuten lang bei etwa 150 °C getrocknet. Nachdem die Unterlage mit den Eingangs- und Ausgangs-Stiften versehen ist, wird die Unterlage einer Lötoperation unterworfen unter Verwendung eines Zinn-/Blei-Lotes (90:10) während 15 Sekunden bei 360 °C. Die Unterlagen werden dann auf eine Temperatur von etwa 150 °C abgeschreckt und mit Perchloräthylen bei einem Druck von etwa 42,2 N/cm² besprüht. Die Maskenzusammensetzung wird dann von der Unterlage entfernt. Ein integriertes Halbleiterchip aus Silicium, welches mit Lötmittel versehen ist, wird im Chip-Anschlussbereich auf die Unterlage aufgebracht und durch Aufschmelzen des Lotes befestigt. Als Ergebnis wird eine ebene Anschlussstelle zwischen Chip und Unterlage erhalten. Tests, mit denen die Zugkraft festgestellt wird, die zur Entfernung des Chips von der Anschlussstelle erforderlich ist, zeigen an, dass die Zugkraft die gleiche ist wie bei einem Standardverfahren, bei dem sowohl das Chip wie auch die Anschlussstelle Lot enthalten.

Beispiel 2

Das allgemeine Verfahren von Beispiel 1 wird wiederholt mit der Ausnahme, dass die verwendete Überzugszusammensetzung etwa 15 Gewichtsteile Shell Epon 28 Harz; etwa 70 Gewichtsteile Zinkoxid mit einer Teilchengrösse von etwa 1 µm und etwa 15 Gewichtsteile Polydimethylsiloxan des Typs, der in Beispiel 1 verwendet wird, enthält. Es werden ähnliche Ergebnisse wie in Beispiel 1 erhalten.

Beispiel 3

Das allgemeine Verfahren von Beispiel 1 wird wiederholt mit der Ausnahme, dass die verwendete Beschichtungszusammensetzung etwa 15 Gewichtsteile Shell Epon 28 Epoxidharz; etwa 70 Gewichtsteile gemahlenes Glas mit einer Teilchengrösse von etwa 10 µm und etwa 15 Gewichtsteile Polydimethylsiloxan des Typs, der in Beispiel 1 verwendet wird, enthält. Es werden ähnliche Ergebnisse wie in Beispiel 1 erhalten.

Beispiel 4

Das allgemeine Verfahren von Beispiel 1 wird wiederholt mit der Ausnahme, dass die Zusammensetzung etwa 20 Gewichtsteile Shell Epon 28 Expoxidharz; etwa 20 Gewichtsteile Polydimethylsiloxan des Typs, der in Beispiel 1 verwendet wird; etwa 32 Gewichtsteile Zinkoxid mit einer Teilchengrösse von etwa 1 µm und etwa 28 Gewichtsteile Glaspulver mit einer Teilchengrösse von etwa 10 µm enthält. Es werden ähnliche Ergebnisse wie in Beispiel 1 erhalten. Die Zusammensetzung wird im wesentlichen während des Abschreckens entfernt.

**Patentansprüche**

1. Im Siebdruck verarbeitbare und wieder entfernbare Lötmaskenzusammensetzung mit einem Gehalt an A) einem filmbildenden Polymeren in flüssiger Form, B) einem das Kleben verhindernden Mittel und C) einem festen, hochtempraturbeständigen Füllstoff, dadurch gekennzeichnet, dass das filmbildende Polymere A) ein Polyepoxid aus Epichlorhydrin und 2,2-Bis(p-hydroxyphenyl)propan mit einer Viskosität von 0,4 bis 3 Pa.s bei 25 °C und einem Molekulargewicht von 170 bis 250 ist; dass das Kleben verhindernde Mittel B) ein flüssiges Siliconöl ist und der feste, hochtemperaturbeständige Füllstoff C) gewählt ist aus der Gruppe von gemahlenem Glas, Zinkoxid, Siliciumdioxid, Aluminiumoxid, Sand und Mischungen derselben.

2. Lötmaskenzusammensetzung nach Anspruch 1, dadurch gekennzeichnet, dass das Verhältnis von A : B zwischen 2:1 und 1:3 und vorzugsweise zwischen 1:1 und 2:3 liegt.

3. Lötmaskenzusammensetzung nach Anspruch 1, dadurch gekennzeichnet, dass das Verhältnis von C : A zwischen 1:6 und 6:1 und vorzugsweise zwischen 2:1 und 6:1 liegt.

4. Lötmaskenzusammensetzung nach Anspruch 1, dadurch gekennzeichnet, dass das das Kleben verhindernde Mittel ein Polydimethylsiloxan mit einer Viskosität von 0,025 bis 0,5 Pa.s und vorzugsweise von 0,1 bis 0,3 Pa.s bei 25 °C ist.

5. Lötmaskenzusammensetzung nach einem oder mehreren der Ansprüche 1 bis 4, dadurch gekennzeichnet, dass sie eine Viskosität von 0,7 bis 15 Pa.s bei 25 °C aufweist.

6. Lötmaskenzusammensetzung nach Anspruch 5, dadurch gekennzeichnet, dass sie eine Viskosität von 1,0 bis 13,0 vorzugsweise von 7,0 bis 12,5 Pa.s bei 25 °C aufweist.

7. Lötmaskenzusammensetzung nach den Ansprüchen 1 und 3, dadurch gekennzeichnet, dass der Füllstoff eine Teilchengrösse von 0,1 bis 20 µm, vorzugsweise von 0,1 bis 5 µm aufweist.

8. Verfahren zum Herstellen einer wieder entfernbaren Lötmaske, dadurch gekennzeichnet, dass eine Lötmaskenzusammensetzung gemäss den Ansprüchen 1 bis 7 im Siebdruck auf eine Unterlage in einem bestimmten Muster aufgetragen und durch Trocknen gehärtet wird und dass die Lötmaske anch dem Auftragen eines Lots, das in den von der Maske nicht bedeckten Bereichen auf der Unterlage haftet, wieder entfernt wird.

9. Verfahren nach Anspruch 8, dadurch gekennzeichnet, dass die Lötmaskenzusammensetzung in einer Schichtdicke von 0,025 bis 0,635 mm, vorzugsweise von 0,127 bis 0,25 mm aufgetragen wird.

10. Verfahren nach Anspruch 9, dadurch gekennzeichnet, dass die Lötmaske durch Trocknen bei einer Temperatur von 50 bis 150 °C gehärtet wird.

11. Verfahren nach Anspruch 8, dadurch gekennzeichnet, dass das Lot bei Temperaturen zwischen 300 und 400 °C aufgetragen wird.

12. Verfahren nach Anspruch 8, dadurch gekennzeichnet, dass die Lötmaske durch Abschrecken der gelöteten Unterlage auf eine Temperatur zwischen 100 und 180 °C unter Einwirken eines Lösungsmittels wieder entfernt wird.

**Claims**

1. Screenable and strippable solder mask composition containing A) a film-forming polymer in liquid form, B) a detackifier, and C) a solid high temperature resistant filler, characterized in that the film-forming polymer A) is a polyepoxide of epichlorohydrin and 2,2-bis(p-hydroxyphenyl)propane with a viscosity of 0.4 to 3 Pa.s at 25 °C, and a molecular weight of 170 to 250; that the detackifier B) is a liquid silicone oil, and the solid high temperature resistant filler C) is selected from the group of ground glass, zinc oxide, silicon dioxide, alumina, sand and mixtures thereof.

2. Solder mask composition as claimed in claim 1, characterized in that the ratio of A : B is between 2:1 and 1:3, and preferably between 1:1 and 2:3.

3. Solder mask composition as claimed in claim 1, characterized in that the ratio of C : A is between 1:6 and 6:1, and preferably between 2:1 and 6:1.

4. Solder mask composition as claimed in claim 1, characterized in that the detackifier is a polydimethylsiloxane with a viscosity of 0.025 to 0.5 Pa.s, and preferably of 0.1 to 0.3 Pa.s at 25 °C.

5. Solder mask composition as claimed in one or several of claims 1 to 4, characterized in that it has a viscosity of 0.7 to 15 Pa.s at 25 °C.

6. Solder mask composition as claimed in claim 5, characterized in that it has a viscosity of 1.0 to 13.0, preferably of 7.0 to 12.5 Pa.s at 25 °C.

7. Solder mask composition as claimed in any one of claims 1 and 3, characterized in that the filler has a particle size of 0.1 to 20 µm, preferably of 0.1 to 5 µm.

8. Method of making a removable solder mask, characterized in that a solder mask composition in accordance with claims 1 to 7 is screen printed on a substrate in a predetermined pattern, and hardened by drying, and that after the application of a solder which adheres to the substrate in the areas not protected by the mask the solder mask is removed again.

9. Method as claimed in claim 8, characterized in that the solder mask composition is applied in a layer thickness of 0.025 to 0.635 mm, preferably to 0.127 to 0.25 mm.

10. Method as claimed in claim 9, characterized in that the solder mask is hardened by drying at a temperature of 50 to 150 °C.

11. Method as claimed in claim 8, characterized in that the solder is applied at temperatures between 300 and 400 °C.

12. Method as claimed in claim 8, characterized in that the solder mask is removed again by quenching the soldered substrate to a temperature between 100 and 180 °C, under the exposure to a solvent.

**Revendications**

1. Composition de masque permettant le dépôt de soudure par sérigraphie et pouvant être décollée ensuite contenant A) un polymère filmogène à l'état fluide, B) un moyen empêchant l'adhérence et C) un matériau de remplissage à l'état solide stable à température élevée, caractérisée en ce que ledit polymère filmogène A) est un polyépoxyde composé d'épichlorhydrine et de 2,2-bis(p-hydroxyphenyle)propane dont la viscosité varie entre 0,4 et 3 Pa.s à 25 °C et dont la masse moléculaire varie entre 170 et 250, ledit moyen empêchant l'adhérence B) est une huile silicone à l'état fluide, ledit matériau de remplissage à l'état solide stable à température élevée C) est choisi dans le groupe comprenant du verre broyé, de l'oxyde de zinc, du dioxyde de silicium, de l'oxyde d'aluminium, du sable et de mélanges de ces matières.

2. Composition de masque selon la revendication 1, caractérisée en ce que le rapport A : B varie entre 2:1 et 1:3, mais se situe de préférence entre 1:1 et 2:3.

3. Composition de masque selon la revendication 1, caractérisée en ce que le rapport C : A varie entre 1:6 et 6:1, mais se situe de préférence entre 2:1 et 6:1.

4. Composition de masque selon la revendication 1, caractérisée en ce que ledit moyen empêchant l'adhérence est un polydimethylsiloxane dont la viscosité varie entre 0,025 et 0,5 Pa.s, mais de préférence entre 0,1 et 0,3 Pa.s, à 25 °C.

5. Composition de masque selon une des revendications 1 à 4, caractérisée en ce que sa viscosité varie entre 0,7 et 15 Pa.s à 25 °C.

6. Composition de masque selon la revendication 5, caractérisée en ce que sa viscosité varie entre 0,1 et 13,0, mais de préférence entre 7,0 et 12,5 Pa.s, à 25 °C.

7. Composition de masque selon les revendications 1 et 3, caractérisée en ce que la taille des particules composant la masse de remplissage varie entre 0,1 et 20 µm, mais de préférence entre 0,1 et 5 µm.

8. Procédé pour fabriquer un masque destiné au dépôt de soudure pouvant être enlevé ensuite, caractérisé en ce que, par sérigraphie, on applique sur une couche une composition de masque permettant le dépôt de soudure selon les revendications 1 à 7 selon une configuration déterminée et qu'on la durcit par séchage, qu'on enlève ledit masque après avoir procédé au dépôt d'un métal d'apport qui adhère dans les régions de ladite couche non recouvertes par ledit masque.

9. Procédé selon la revendication 8, caractérisé en ce que la composition de masque a une épaisseur comprise entre 0,025 et 0,635 mm, mais de préférence entre 0,127 et 0,25 mm.

10. Procédé selon la revendication 9, caractérisé en ce qu'on durcit ledit masque par séchage à une température comprise entre 50 et 150 °C.

11. Procédé selon la revendication 8, caractérisé en ce que le métal d'apport est appliqué à des températures comprises entre 300 et 400 °C.

12. Procédé selon la revendication 8, caractérisé en ce qu'on enlève ledit masque par la trempe de ladite couche et soudée au moyen d'un agent solvant à une température comprise entre 100 et 180 °C.